## Europäisches Patentamt
## European Patent Office
## Office européen des brevets

(11) Numéro de publication: **0 370 877**
**A1**

# DEMANDE DE BREVET EUROPEEN

(21) Numéro de dépôt: **89403170.7**

(22) Date de dépôt: **17.11.89**

(51) Int. Cl.⁵: **H03F 1/32**

(30) Priorité: **25.11.88 FR 8815411**

(43) Date de publication de la demande:
**30.05.90 Bulletin 90/22**

(84) Etats contractants désignés:
**AT BE CH DE ES FR GB GR IT LI LU NL SE**

(71) Demandeur: **THOMSON-CSF**
**51, Esplanade du Général de Gaulle**
**F-92800 Puteaux(FR)**

(72) Inventeur: **Boulanger, Alain**
**THOMSON-CSF SCPI Cédex 67**
**F-92045 Paris la Défense(FR)**
Inventeur: **Creff, Jacques**
**THOMSON-CSF SCPI Cédex 67**
**F-92045 Paris la Défense(FR)**

(74) Mandataire: **Chaverneff, Vladimir et al**
**THOMSON-CSF SCPI**
**F-92045 PARIS LA DEFENSE CEDEX 67(FR)**

(54) **Dispositif de correction de phase induite par le fonctionnement en classe C de l'amplificateur "état solide", et chaîne radar utilisant un tel dispositif.**

(57) La présente invention concerne un dispositif de correction de phase induite par le fonctionnement en classe C d'amplificateur "état solide". Elle trouve application dans le domaine de la fabrication des émetteurs radar pulsés.

Les amplis "état solide" sont sujets à engendrer des variations de phase. L'invention concerne une boucle de mesure et de correction qui permet en temps réel d'effacer les variations de phase dûes aux échauffements.

fig. 1

EP 0 370 877 A1

# DISPOSITIF DE CORRECTION DE PHASE INDUITE PAR LE FONCTIONNEMENT EN CLASSE C DE L'AMPLIFICATEUR "ETAT SOLIDE" ET CHAINE RADAR UTILISANT UN TEL DISPOSITIF

La présente invention concerne un dispositif de correction de phase induite par le fonctionnement en classe C d'amplificateur "état solide". Elle trouve application dans le domaine de la fabrication des émetteurs radar pulsés.

Dans les radars modernes, les ondes électromagnétiques émises sont engendrées par un dispositif à composants semiconducteurs utilisant des transistors hyperfréquence. Les caractéristiques du radar sont directement liées à la fonction de transfert. Or, celle ci dépend des conditions de fonctionnement de la chaine.

Dans la majorité des applications du radar, l'effet Doppler affecte les signaux renvoyés par les cibles mobiles, permettant d'éliminer les échos fixes. Ainsi, dans le cas d'un radar à compression d'impulsions, au codage de phase ou de fréquence s'ajoute un décalage fréquentiel dû à l'effet Doppler.

Or, la qualité du radar à compression d'impulsions dépend essentiellement de la capacité à fournir une chaine de réception dont la fonction de transfert soit rigoureusement inverse de celle de la chaîne d'émission. Quand on travaille avec des étages de puissance en technologie "état solide", les étages d'amplification travaillent en classe C. Les puissances crêtes sont plus faibles que dans le cas des technologies à tubes (klystrons, Tubes à Ondes Progressives, etc.) mais la puissance moyenne développée peut être élevée pour permettre un facteur de forme convenable.

Les puissances désirées sont obtenues en groupant des étages de puissance en cascade pilotés par des transistors bas niveau.La puissance finale est obtenue par des sommateurs (montages Wilkinson, anneaux 3dB, ...). Ces montages permettent de conserver toujours une puissance suffisante même en cas de défaillance de quelques étages qui sont remplacés automatiquement.

Cependant, les semiconducteurs de puissance sont soumis à deux types de phénomènes négatifs pour leur usage en radar impulsionnel. Tout d'abord, la puissance instantanée varie au cours de l'impulsion. Puis, la phase varie.

Dans la démarche de l'invention, on a découvert que ces phénomènes étaient dus à des variations considérables de température de jonction dans les transistors de puissance des étages finaux. En classe C impulsionnelle, les jonctions passent de la dissipation nulle avant la montée de l'impulsion à la dissipation maximale quand la puissance d'impulsion est à sa valeur maximale. Or, les rendements des transistors étant dans cette gamme de l'ordre de quarante pour cent, la dissipation thermique est importante pendant la durée de l'impulsion. La résistance thermique jonction/boitier de chaque transistor, aussi faible soit-elle, entraîne que la température évolue lors de l'impulsion au lieu de rester constante selon la théorie du radar parfait.

Comme, de plus, les radars peuvent travailler en excursion de fréquence, ou encore en diversité de fréquence, ou en fréquence wobbulée de manière aléatoire pour éviter les contre-mesures, les variations de température deviennent rédhibitoires.

En effet, elles sont responsables de variations de la phase et de l'amplitude du signal émis. En traitement Doppler, le problème est encore augmenté par le fait que le radar crée une bande de fréquences Doppler parasites.

La solution évidente qui consiste à refroidir les jonctions des transistors pendant la relaxation entre deux impulsions est sans application ici, puisque les largeurs des impulsions et les durées de relaxation peuvent varier considérablement sans lien direct entre elles.

C'est un but de la présente invention de permettre un contrôle efficace de la phase du signal sortant des étages de puissance d'un amplificateur "état solide" en classe C, même quand les taux de répétition ne sont pas constants ni même continument variables.

C'est un autre but de la présente invention de proposer un moyen simple pour admettre une correction de la fonction de transfert de la chaîne radar qui réduise considérablement les variations de phase dans l'impulsion émise quels que soient les paramètres du système : agilité de fréquence ou wobbulation notamment. En effet, la présente invention concerne un dispositif de correction de phase induite par le fonctionnement en classe C d'un amplificateur "état solide" à signaux impulsionnels. L'invention se caractérise notamment par le fait que la chaîne d'amplification à corriger comporte un déphaseur disposé à l'entrée de l'amplificateur et commandable par la mesure de la différence de phase instantanée entre la tension d'entrée et la tension de sortie de cet amplificateur.

D'autres caractéristiques et avantages de la présente invention apparaitront plus clairement à l'aide de la description et des figures qui sont :

- la figure 1 : un schéma de fonctionnement de principe de l'invention,

- la figure 2 : un schéma général d'une chaîne d'amplification impulsionnelle en technologie "état solide" à plusieurs étages avec le dispositif selon l'invention,

- la figure 3 : un chronogramme associé au fonctionnement de la figure,

- la figure 4 : un schéma d'un autre mode de réalisation de chaîne radar selon l'invention,

- la figure 5 : un schéma de réalisation de déphaseur utilisable selon l'invention.

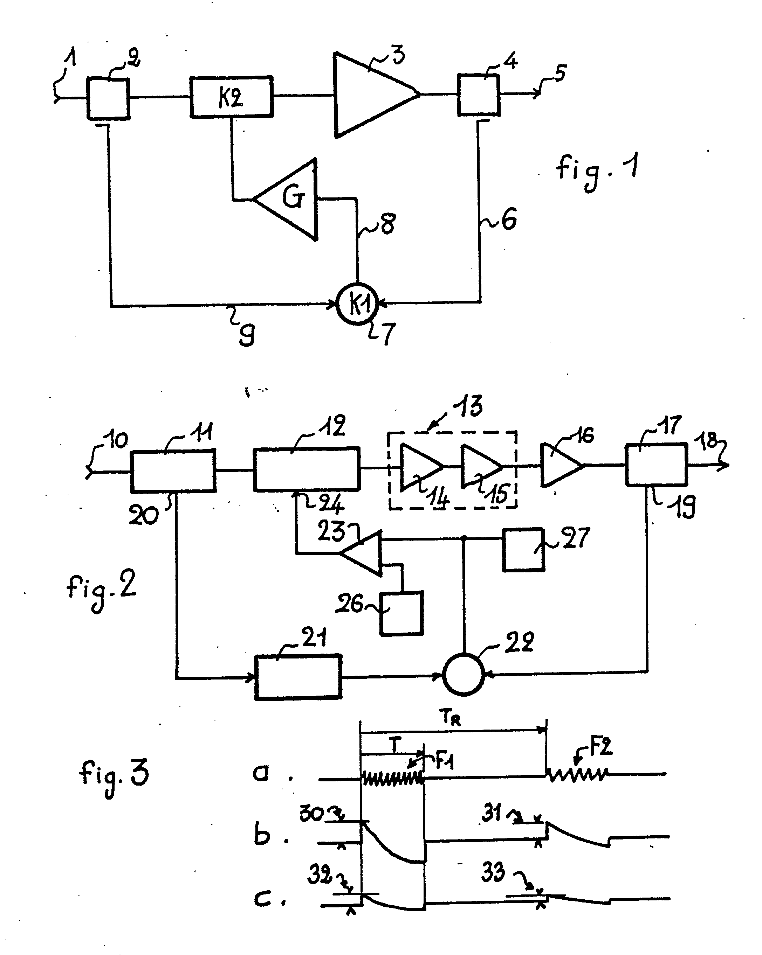

A la figure 1, on a représenté un schéma d'une chaîne de réduction de la phase créée dans les étages de puissance impulsionnelle selon l'invention. Le signal d'entrée 1 est saisi par un coupleur 2. Le signal est ensuite fourni à un déphaseur commandable K2 qui attaque l'étage de puissance impulsionnel. La sortie de celui-ci est connectée à un coupleur de sortie 4 qui émet le signal de sortie 5 et un signal en 6 vers la boucle à correction de phase.

La boucle est fermée par un détecteur de phase K1 qui élabore le signal de différence de phase entre les deux coupleurs 2 et 4. Ce signal d'écart est transmis par le chemin 8 à travers un amplificateur d'adaptation G à l'entrée de commande de phase du déphaseur commandable K2.

Cette boucle déphaseur / détecteur de phase / amplificateur constitue le système de mesure et de correction des dérives de phase induites par les étages de puissance en état solide.

Dans un mode de réalisation représenté à la figure 2, l'amplificateur G est remplacé par un amplificateur différentiel 23 qui joue aussi un rôle dans l'élaboration de la phase de correction.

Le signal d'entrée 10 est fourni à un coupleur 11 puis à un déphaseur 12, dont la phase est commandée par son entrée 24. La chaîne d'amplification est constituée par un amplificateur bas niveau 13 constitué de plusieurs éléments 14 et 15 cascadés et d'un amplificateur de puissance 16 proprement dit. Un coupleur de sortie 17 fournit le signal de sortie 18. Comme selon le principe indiqué à la figure 1, la boucle de correction est composée par un captage 20 de la phase du signal d'entrée par le coupleur d'entrée 11 auquel est appliqué un retard d'égalisation par une ligne à retard 21. En effet, on sait que l'amplification en puissance d'un signal hyperfréquence entraîne un retard de propagation. Pour équilibrer ce retard, il faut insérer une ligne à retard sur la voie référence du détecteur de phase.

Le signal de captage est ensuite comparé par un détecteur de phase 22 avec la phase du signal de sortie captée sur le coupleur de sortie 17 par sa sortie 19.

Le remplacement de l'amplificateur G par une chaîne plus complexe permet de répondre à un autre problème entraîné par la spécificité de l'invention. Cette variante est représentée dans un mode de réalisation à la figure 2.

En agilité de fréquence, la différence de phase entre les deux signaux doit se maintenir en valeur absolue dans la plage de convergence de la boucle. Mais, non seulement le retard se manifeste en phase sur le signal, mais aussi en propagation de groupe. Pour recaler ces retards, il faut déplacer le point de travail de la boucle correctrice par rapport au point de prépolarisation correspondant à la correction de la phase pure.

A cette fin, on fournit à un amplificateur différentiel 23, un signal d'entrée de tension de prépolarisation qui fixe le point médian de la caractéristique de commande de façon à ce que le déphaseur 12 puisse introduire un retard ou une avance de phase. Dans le cas où cette correction de retard de groupe ne peut plus être compensée sans risquer de sortir de la zone de convergence de la boucle, il faut alors disposer des cellules correctrices spécialisées, qui sont des composants connus de l'homme de métier, sur ce type de retard.

Dans un premier mode de réalisation, cette structure correctrice du temps de propagation de groupe est insérée dans la voie de référence du détecteur de phase avec un signe donné.

Dans un second mode de réalisation, ces cellules de correction de retard de groupe sont introduites directement dans la chaîne d'amplification. Le signe de la correction est alors inversé.

Depuis le capteur d'entrée 11, on remarque à la figure 2 que la sortie 20 de ce capteur est transmise à l'entrée d'une ligne à retard 21.

De même, un coupleur de sortie 17 prélève un signal 19 qui est mélangé avec le signal prélevé en entrée et retardé dans un détecteur de phase 22. Le signal de mélange est fourni à l'entrée de l'amplificateur 23 monté en comparateur avec la tension de prépolarisation. Le signal résultant de la comparaison est appliqué à un déphaseur 12 à diodes, par son entrée de commande 24. La sortie du déphaseur 12 est transmise à la chaîne d'amplification 13. Celle-ci est composée d'amplificateurs de bas niveau 14, 15 qui amènent le signal traité à un niveau de puissance moyenne, puis à un amplificateur "état solide" 16 de forte puissance.

Toute dérive due aux effets précités, sera prise en compte, détectée sur le coupleur de sortie 17 et ramené en signal de commande sur le déphaseur 12.

A la figure 3, on a représenté les chronogrammes de trois signaux caractéristiques de l'invention. Le signal a. est le signal d'entrée dans l'amplificateur de puissance qui fonctionne en classe C. Il est constitué par une suite d'impulsions dont la Nième est de durée T et la $N+1$ième est séparée de la précédente d'une période TR. En agilité de fréquence, le premier train d'impulsions est en fréquence F1 et le second en fréquence F2.

C'est la mesure instantanée du temps de propagation de groupe au niveau de l'amplificateur "état solide" fonctionnant en classe C qui permet de régler le déphasage et de mesurer la variation du temps de groupe dans la plage de fonctionnement en fréquence.

La courbe b. mesure ainsi le déphasage qui serait effectué au transfert en boucle ouverte. On remarque l'amplitude importante du déphasage introduit par l'amplificateur et sa variation d'une récurrence à F1 à une autre récurrence à F2. La courbe c. mesure le même déphasage en boucle fermée. On remarque la diminution des variations et une relative insensibilité à la fréquence de récurrence.

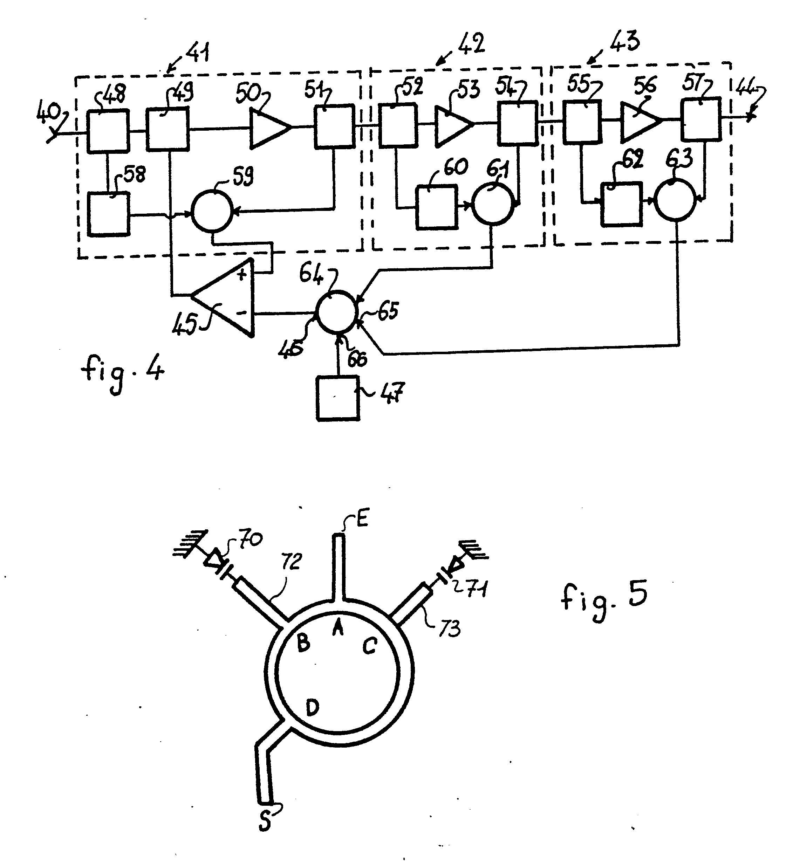

A la figure 4, on a représenté un autre mode de réalisation de l'invention. Le signal d'entrée est fourni à une borne 40 du circuit d'amplification au niveau de l'entrée de la section dite à moyenne puissance. Le circuit d'amplification est ensuite réparti en trois sections respectivement 41 dite moyenne puissance, 42 dite forte puissance et 43 dite "booster". Cet étagement des puissances permet de recaler les dérives propres à chaque classe d'amplification de manière plus fine que la correction globale prévue en figures 1 ou 2.

Chaque amplificateur 50, 53, 56 se caractérise par un retard de propagation dit T1 en basse puissance, T2 en puissance élevée et T3 en très forte puissance . Ces retards sont compensés par des lignes à retard dans les voies de mesure propres à chaque niveau de puissance. Ainsi, les signaux d'entrée et de sortie de chacun des niveaux 41, 42, 43 sont prélevés sur des coupleurs 48, 52, 55 en entrée et 51, 54, 57 en sortie. Dans chaque niveau, le signal d'entrée prélevé est transmis par une ligne à retard 58 de valeur T1, 60 de valeur T2 et 62 de valeur T3.

Un détecteur de phase propre à chaque niveau, respectivement 59, 61 et 63 élabore alors le signal d'erreur dû à chaque zone d'amplification 41, 42, 43. Les signaux de déphasage sont composés sur un additionneur 45, 64 avec des coefficients de pondération qui caractérisent le niveau de puissance du signal de déphasage de chaque niveau. De plus, une source de tension 47 de prépositionnement fournit un signal de prépolarisation analogue à celui du montage de la figure 2, par une entrée spécialisée 66 de l'additionneur 64. Le signal d'addition partielle des niveaux très forte puissance et forte puissance est ajouté au signal de dérive issu du détecteur de phase 59 des moyennes puissances, et le signal résultant est fourni à un unique déphaseur 49 inséré en amont de l'amplificateur moyenne puissance 49. Le résultat est tout à fait conséquent. En effet, l'excursion de puissance est réduite dans la section 41 et toute correction dans cette section est beaucoup plus rapide et donc efficace que dans les sections suivantes.

Il faut noter qu'une différence dans les fonctions de transfert entre deux détecteurs comme les détecteurs 59, 61, 63, est susceptible d'entraîner des erreurs proportionnelles à l'écart de pente entre ces fonctions. Il faut donc réaliser un réglage préalable d'égalisation des paramètres de transfert de tous les détecteurs de phase. Cette égalisation doit rester monotone dans la gamme de fréquences d'utilisation du système. A la figure 5, on a représenté un mode de réalisation d'un déphaseur variable à phase commandable. On exploite le phénomène de réflexion d'une onde hyperfréquence sur un élément capacitif disposé à l'extrémité d'une ligne hyperfréquence de longueur déterminée relativement à la bande de fréquence d'emploi de l'appareil. On dispose à l'extrémité de la ligne une capacité variable constituée par une diode varactor polarisée en inverse. La ligne est en fait une jonction dite à 3 dB réalisée par un anneau 6 λ/4.

De l'entrée E de l'anneau visible à la figure 5, le signal hyperfréquence se divise en deux dans les branches B et C. Les signaux se réfléchissent sur les varactors 70 et 71. Sur la voie 72 issue de B, on dispose une longueur λ/4 supplémentaire à la longueur de la voie 73 issue de C. Le résultat est que les signaux réfléchis sur les deux varactors, sont déphasés à leur retour en B et C de 180°. Puis, ils se recombinent sur la voie D avec un déphasage total dû aux déphasages introduits par les varactors et dû aux longueurs de lignes dans l'anneau.

Il est ainsi possible de faire varier le déphasage par la commande des deux varactors.

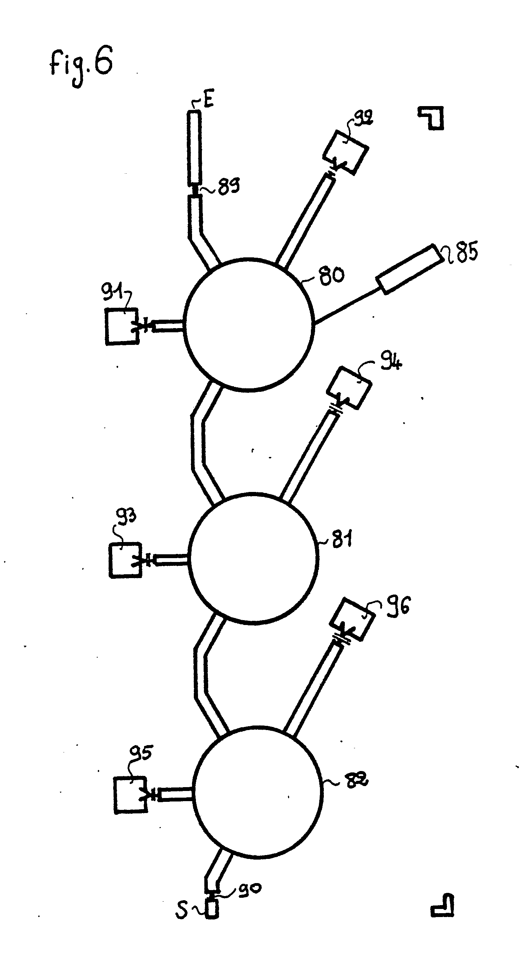

A la figure 6, on a représenté un montage déphaseur à trois anneaux comme l'anneau de la figure 5 de façon à obtenir une excursion de phase suffisante sans sortir du domaine de comportement fréquentiel du montage.

Les bornes d'entrée E sur l'anneau 80 et de sortie S sur l'anneau 82 sont connectées par des capacités 89 et 90 de façon à ce que, en l'absence de signal de commande, le déphasage introduit soit nul. Les capacités des 6 varactors 83-88 sont variables sous l'action du signal de commande appliqué sur la ligne 85. Les bornes 91-96 reçoivent les polarisations des diodes. Les trois anneaux représentés, et qui peuvent être en plus grand nombre, sont connectés en série, l'entrée de l'anneau suivant étant connectée à la sortie de l'anneau précédent dans la série en se dirigeant de l'entrée vers la sortie.

Le résultat est que le déphaseur proposé permet une correction de la phase extrêmement rapide et que de plus, il est capable d'agir dans une large plage de fréquences avec une excursion convenable en phase.

**Revendications**

1. Dispositif de correction de phase induite par le fonctionnement en classe C d'un amplificateur "état solide" pour produire des ondes hyperfréquences comme pour un émetteur radar, caractérisé notamment par le fait que la chaîne d'amplification à corriger comporte un déphaseur (K2) disposé à l'entrée de l'amplificateur (3) et commandable par la mesure (K1) de la différence de phase instantanée entre la tension d'entrée et la tension de sortie de cet amplificateur (3).

2. Dispositif selon la revendication 1, caractérisé en ce qu'une ligne à retard d'égalisation (21) est introduite sur la voie de captage (20) de la phase du signal d'entrée pour équilibrer les retards introduits par la chaîne d'amplification (13, 16), en particulier pour un fonctionnement de la chaîne d'amplification en agilité de fréquence.

3. Dispositif selon la revendication 1, caractérisé en ce que le signal de commande du déphaseur est fourni par la sortie d'un amplificateur (23) qui compare la variation de phase de transfert entrée/sortie issue d'un détecteur de phase (22) à un signal issu d'une source de tension réglable (27) autour d'une valeur de prépolarisation, de façon à permettre une excursion de phase autour d'une valeur centrale.

4. Dispositif selon la revendication 1, caractérisé en ce que la correction est assurée dans la seule section moyenne puissance (41) d'une chaîne d'amplification constituée d'une série d'étages d'amplifications de puissances croissantes, les signaux de déphasage étant mesurés séparément sur chaque section de puissance (41-43) de la chaîne d'amplification "état solide".

5. Dispositif selon la revendication 4, caractérisé en ce que chaque section de puissance (41, 42, 43) comprend un amplificateur (50, 53, 56) encadré entre deux coupleurs d'entrée (48, 52, 55) et de sortie (51, 54, 57) qui prélèvent des signaux d'entrée retardés par des lignes à retard (58, 60, 62) et des signaux de sortie dont les déphasages respectifs sont mesurés par des détecteurs de phase (59, 61, 63), les signaux de déphasage étant combinés dans un dispositif (45, 65) destiné à commander un déphaseur (49) à phase commandable inséré entre le coupleur d'entrée (48) du premier étage moyenne puissance (41) et l'amplificateur (50) proprement dit.

6. Dispositif selon la revendication 5, caractérisé en ce que le dispositif de composition comporte un premier additionneur (64) dont les entrées reçoivent les signaux de déphasage des étages (42, 43) de plus fortes puissances, et un signal de prépolarisation d'une source de tension (47), le signal résultant correspondant à une pondération des différents signaux, la sortie (46) étant connectée à une première entrée d'un amplificateur (45), et le signal de déphasage de la chaîne de mesure de l'étage moyenne puissance (41) étant fourni à une seconde entrée.

7. Dispositif selon la revendication 1, caractérisé en ce que le déphaseur est du type à anneau hybride avec deux varactors (70, 71) et une borne de commande qui permet de fournir un signal de sortie (S) déphasé relativement au signal d'entrée.

8. Dispositif selon la revendication 7, caractérisé en ce que le déphaseur comporte plusieurs anneaux connectés en série de façon à augmenter l'excursion en phase, le signal de commande étant appliqué à l'entrée d'une ligne hyperfréquence (85) disposée en un point prédéterminé sur l'anneau (80) qui porte la borne d'entrée (E).

9. Chaîne radar du type utilisant un générateur hyperfréquence à amplificateur "état solide", caractérisée en ce qu'elle comporte un dispositif de correction des variations de phase selon l'une des revendications précédentes.

fig. 1

fig. 2

fig. 3

fig. 4

fig. 5

fig.6

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | US-A-4 276 514 (M.Y. HUANG)<br>* Figure 1; colonne 1, lignes 30-68; colonne 3, ligne 16 - colonne 5, ligne 32 *<br>--- | 1,2 | H 03 F 1/32 |
| Y | US-A-4 554 514 (J.C. WHARTENBY et al.)<br>* Figure 1; colonne 2, ligne 22 - colonne 4, ligne 32 * | 1,2 | |
| A | ---| 3 | |
| A | EP-A-0 248 425 (LICENTIA PATENT-VERWALTUNGS-GmbH)<br>* Figure 7; page 2, ligne 50 - page 3, ligne 31; page 4, lignes 39-46 *<br>--- | 1,3 | |
| A | ELECTRONICS LETTERS, vol. 7, no. 7, 8 avril 1971, pages 145-146, Hitchin, GB; T. ARTHANAYAKE et al.: "Linear amplification using envelope feedback"<br>* Figure 1; page 145, colonne de gauche, lignes 12-20 *<br>--- | 1,3,4 | |
| A | US-A-4 122 399 (G.L. HEITER et al.)<br>* Figures 7,8; colonne 4, lignes 31-54 *<br>----- | 7,8 | DOMAINES TECHNIQUES RECHERCHES (Int. Cl.5)<br><br>H 03 F |

Le présent rapport a été établi pour toutes les revendications

| Lieu de la recherche | Date d'achèvement de la recherche | Examinateur |
|---|---|---|
| LA HAYE | 26-02-1990 | TYBERGHIEN G.M.P. |